(19) Europäisches Patentamt
European Patent Office
Office européen des brevets

(11) **EP 1 273 100 B1**

(12) **EUROPÄISCHE PATENTSCHRIFT**

(45) Veröffentlichungstag und Bekanntmachung des Hinweises auf die Patenterteilung:
**13.10.2004 Patentblatt 2004/42**

(51) Int Cl.[7]: **H03K 5/24**, H03F 3/45, H03H 11/12, H03M 3/02, H03H 11/32

(21) Anmeldenummer: **00912456.1**

(22) Anmeldetag: **11.02.2000**

(86) Internationale Anmeldenummer:
**PCT/EP2000/001134**

(87) Internationale Veröffentlichungsnummer:
**WO 2001/059928 (16.08.2001 Gazette 2001/33)**

(54) **SYMMETRIERSCHALTUNGSANORDNUNG**

BALANCED CIRCUIT ARRANGEMENT

CIRCUIT D'EQUILIBRAGE

(84) Benannte Vertragsstaaten:
**AT BE CH CY DE DK ES FI FR GB GR IE IT LI LU MC NL PT SE**

(43) Veröffentlichungstag der Anmeldung:
**08.01.2003 Patentblatt 2003/02**

(73) Patentinhaber: **Georg Neumann GmbH**
**13403 Berlin (DE)**

(72) Erfinder: **KERN, Otmar**
**D-14167 Berlin (DE)**

(74) Vertreter: **Konle, Tilmar, Dipl.-Ing.**
**Benderstrasse 23 a**
**81247 München (DE)**

(56) Entgegenhaltungen:
| EP-A- 0 375 195 | EP-A- 0 415 080 |
| EP-A- 0 712 002 | DD-A- 252 716 |
| DE-A- 2 629 172 | FR-A- 2 778 513 |
| US-A- 4 764 752 | US-A- 5 294 783 |
| US-A- 5 592 167 | US-A- 5 872 482 |

EP 1 273 100 B1

**Beschreibung**

Die Erfindung bezieht sich auf eine Symmetrierschaltungsanordnung gemäß dem Oberbegriff des Patentanspruch 1. Eine derartige Schaltungsanordnung ist allgemein bekannt.

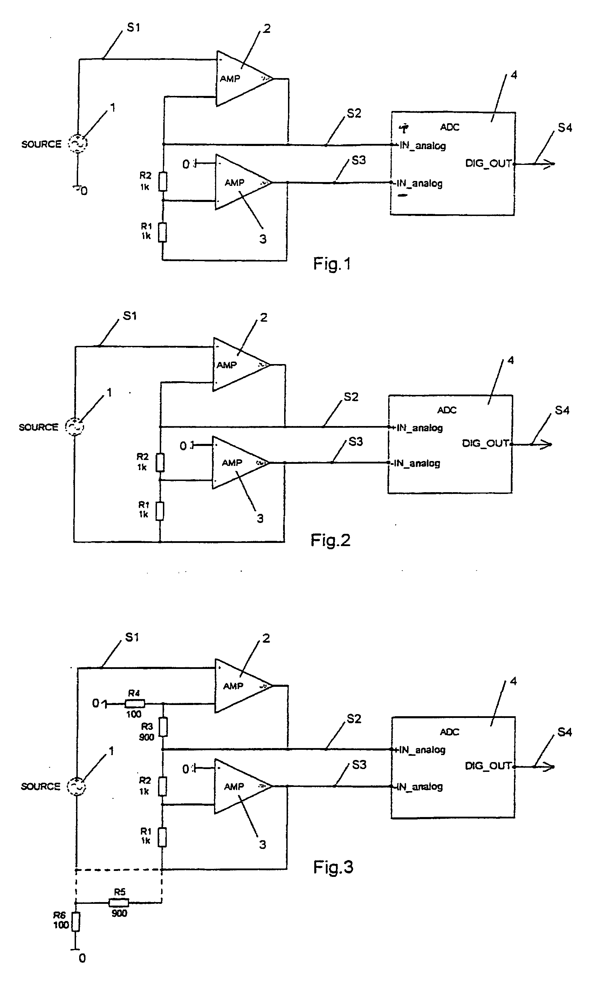

Zur Umwandlung eines analogen Signals, beispielsweise des Ausgangssignals einer Kondensatormikrofonkapsel, in ein digitales Signal werden üblicherweise hochauflösende Delta-Sigma-Wandler verwendet. Derartige Wandler arbeiten technologisch bedingt an einer Betriebsspannung von +5 Volt und weisen symmetrische Analog-Eingänge auf. Die zulässigen analogen Eingangspegel für Vollaussteuerungen werden hierbei mit maximal +/-1,25 Volt gegenphasig zu jedem Eingangsanschluß definiert, was einem Differenzsignal von +/- 2,5 Volt entspricht. Ein asymmetrisches analoges Eingangssignal, wie es beispielsweise von einer Kondensator-Mikrofonkapsel hinter dem Impedanzwandler zur Verfügung gestellt wird, muß daher stets zusätzlich invertiert werden. Eine hierfür geeignete Symmetrierschaltungsanordnung nach dem Stand der Technik ist in Figur 1 dargestellt.

In Figur 1 wird das Ausgangssignal S1 einer Signalquelle 1, beispielsweise einer Mikrofonkapsel, auf den nicht-invertierenden Eingang eines ersten Verstärkers 2 geschaltet. Damit der erste Verstärker 2 die Verstärkung V=+1 besitzt, wird dessen Ausgangssignal S2 unvermindert im Sinne einer Gegenkopplung auf den invertierenden Eingang des Verstärkers 2 rückgeführt. Des weiteren wird das Signal S2 auf den nicht-invertierenden Eingang eines Analog-Digital-Wandlers 4 geführt. Weiterhin wird das Ausgangssignal S2 des ersten Verstärkers 2 über einen Vorwiderstand R2 mit dem invertierenden Eingang eines zweiten Verstärkers 3 verbunden. Der nicht-invertierende Eingang des zweiten Verstärkers 3 liegt auf Masse bzw. Bezugspotential. Das Ausgangssignal S3 des zweiten Verstärkers 3 wird dem invertierenden Eingang des Analog-Digital-Wandlers 4 zugeführt und wird ferner über einen Widerstand R1 im Sinne einer Gegenkopplung auf den invertierenden Eingang des zweiten Verstärkers 3 rückgeführt. Der Gegenkopplungswiderstand R1 besitzt den gleichen Wert wie der Vorwiderstand R2. Durch diese Beschaltung besitzt der zweite Verstärker 3 für sein Eingangssignal S2 den Verstärkungsgrad V = - 1. Das Ausgangssignal S3 des zweiten Verstärkers 3 ist betragsmäßig gleich dem Ausgangssignal S2 des ersten Verstärkers 2 und ist gegenüber dem Signal S2 invertiert. Das am Ausgang des Analog-Digital-Wandlers 4 erzeugte digitale Signal S4 stellt das Differenzsignal zwischen den Eingangssignalen S2 und S3 des Wandlers 4 dar und entspricht daher betragsmäßig dem doppelten Wert des Signals S2.

Die Symmetrierschaltungsanordnung nach Fig. 1 besitzt folgende Nachteile:

- Das Signal S1 der Signalquelle 1 wird - bezogen auf den symmetrischen Eingang des Analog-Digital-Wandlers 4 - um den Faktor 2 verstärkt, so daß nur ein maximaler Quellensignalpegel von +/-1,25 Volt verarbeitet werden kann. Die in modernen analogen Kondensatormikrofonkapseln verarbeiten Spitzenamplituden liegen jedoch deutlich höher.

- Der zweite Verstärker 3 addiert zu dem Rauschen des ersten Verstärkers 2 eigene Rauschanteile überproportional hinzu. Dies liegt daran, daß das im zweiten Verstärker 3 entstehende Rauschen stets so erscheint, als ob es an seinem invertierenden Eingang eingespeist würde. Während demzufolge der Verstärkungsgrad des zweiten Verstärkers 3 für das Nutzsignal mittels der Widerstände R1, R2 auf V = - 1 eingestellt ist, wird das Rauschen des zweiten Verstärkers 3 wie ein in seinen nicht-invertierenden Eingang eingespeistes Signal entsprechend der Formel (R1 + R2) / R2 = 2 verstärkt.

Die Aufgabe der Erfindung besteht demgegenüber darin, eine Symmetrierschaltungsanordnung zu schaffen, welche höhere maximale Pegel des Quellensignals verarbeiten kann und rauschärmer ist.

Diese Aufgabe wird erfindungsgemäß durch die kennzeichnenden Merkmale des Anspruchs 1 gelöst.

Vorteilhafte Ausgestaltungen und Weiterbildungen der Symmetrierschaltungsanordnung nach Anspruch 1 ergeben sich aus den Unteransprüchen.

Die Erfindung wird anhand von Ausführungsbeispielen in den Zeichnungen näher erläutert. Es zeigt:

Fig. 2 ein elektrisches Schaltbild eines ersten Ausführungsbeispiels einer erfindungsgemäßen Symmetrierschaltungsanordnung, und

Fig. 3 ein elektrisches Schaltbild eines weiteren Ausführungsbeispiels einer erfindungsgemäßen Symmetrierschaltungsanordnung.

Bei der in Figur 2 dargestellten Symmetrierschaltungsanordnung ist prinzipiell derselbe Schaltungsaufbau wie nach Fig. 1 vorgesehen, wobei jedoch im Unterschied zu Fig. 1 das Ausgangssignal S3 des Verstärkers 3 nicht nur auf den invertierenden Eingang des zweiten Verstärkers 3 gegengekoppelt wird, sondern gleichzeitig auch dem Fußpunkt der Signalquelle 1 zugeführt wird. Hierdurch entsteht die Wirkung einer Gegenkopplung, die den Fußpunkt der Signalquelle 1 mit entgegengesetztem Vorzeichen, verglichen mit deren Ausgangssignal S1, ansteuert. Die vorzeichenrichtige Addition der beiden Signalspannungen S1 und S3 ergibt automatisch den Spannungsbetrag, welcher von der Signalquelle 1 zwischen ihren beiden Anschlüssen generiert wird.

Aufgrund der Gegenkopplung des Signals S3 auf den Fußpunkt der Signalquelle 1 vermindert sich die Signalspannung S1 - bezogen auf Bezugspotential bzw.

Masse - um den Betrag der Signalspannung S3 entsprechend der Beziehung

$$- 1/2 \times V_{ges},$$

wobei $V_{ges}$ die Gesamtverstärkung des geschlossenen Regelkreises der Schaltungsanordnung zwischen Ausgang und Fußpunkt der Signalquelle 1 ist. Die Gesamtverstärkung $V_{ges}$ besitzt im Falle der Schaltungsanordnung nach Fig. 1 den Wert $V_{ges} = - 1$. Damit vermindert sich die Signalspannung S1 auf die Hälfte des bei der Schaltungsanordnung nach Fig. 1 vorhandenen Wertes. Auf diese Weise führt nun auch die Signalspannungsquelle 1 an ihren beiden Anschlüssen ein symmetrisches Signal mit dem gleichen Betrag wie das Differenzsignal zwischen den Ausgängen der Verstärker 2 und 3 bzw. dem symmetrischen Eingang des Analog-Digital-Wandlers 4. Der Grad der Verstärkung zwischen der Signalquelle 1 und dem Eingang des Analog-Digital-Wandlers 4 beträgt nur noch V=1, so daß Signalamplituden von S1 bis +/- 2,5 Volt übertragen werden können.

Darüber hinaus ergibt sich ein weiterer wesentlicher Vorteil. Das unerwünschte Eigenrauschen des Verstärkers 3 wird hinsichtlich des auf Differenzsignale reagierenden Eingangs des Analog-Digital-Wandlers 4 vollständig beseitigt. Diese Wirkung entsteht dadurch, daß das am Ausgang des Verstärkers 3 entstehende Rauschen unvermindert über den Fußpunkt der Signalquelle 1 an den Eingang bzw. Ausgang des ersten Verstärkers 2 gelangt und dort mit gleichem Betrag und gleicher Phasenlage wie am Ausgang des zweiten Verstärkers 3 auftritt. Da der Ausgang des ersten Verstärkers 2 gleichzeitig den Fußpunkt des aus den Widerständen R1 und R2 gebildeten Gegenkopplungs-Spannungsteilers bildet, werden nicht-invertierte Signalanteile des zweiten Verstärkers 3, d.h., dessen Eigenrauschen, nicht mehr in Richtung seines invertierenden Eingangs geteilt. Demzufolge wird dieses Rauschen nicht mehr, wie im Falle der Schaltungsanordnung nach Fig. 1, um den Faktor 2 verstärkt, sondern erhält die Verstärkung V = 1. Da das Rauschen mit gleichem Betrag und gleicher Phasenlage sowohl am Ausgang des zweiten Verstärkers 3 als auch am Ausgang des ersten Verstärkers 2 vorhanden ist, wird es von dem nur auf gegenphasige Signale reagierenden Analog-Digital-Wandler 4 nicht mehr erfaßt, sondern unterdrückt. Dieser Wirkungsmechanismus bleibt auch dann erhalten, wenn für bestimmte Betriebsfälle eine Signalverstärkung zwischen der Signalquelle 1 und dem Analog-Digital-Wandler 4 gewünscht wird. Eine solche Verstärkung kann, wie anhand der Ausführungsform nach Fig. 3 gezeigt ist, durch Spannungsteilung im Gegenkopplungspfad des Verstärkers 2 eingestellt werden. Hierzu dienen in Fig. 3 die Widerstände R3 und R4. Durch die Wirkung der geschlossenen Regelschleife wird das Rauschen des zweiten Verstärkers 3 an seinem Ausgang um das Maß der eingestellten Verstärkung des ersten Verstärkers 2 negativ verstärkt, d.h., weitgehend unterdrückt, während es am Ausgang des ersten Verstärkers 2 unverändert mit dem Verstärkungsgrad V = 1 vorhanden ist. Des weiteren erscheint die abgegebene Signalspannung S1 der Signalquelle 1 nicht mehr symmetrisch bezogen auf den Bezugspotential bzw. Masse, sondern nur noch als Addition der Signalspannungen S1 und S3, wobei die Signalspannung S3 um den Betrag der Verstärkung des ersten Verstärkers 2 größer ist als die Signalspannung S1. Dies hat im allgemeinen keine Nachteile, während die Rauschspannung aus dem zweiten Verstärker 3 am Eingang des Analog-Digital-Wandlers 4 im Vergleich zu den Verhältnissen bei der bekannten Schaltungsanordnung nach Fig. 1 annähernd halbiert wird.

Durch Einfügen eines weiteren Spannungsteilers R5 und R6, der bevorzugt dasselbe Teilungsverhältnis aufweist wie die Widerstände R1 und R4, kann das auf den Fußpunkt der Signalquelle 1 rückgeführte Signal S3 wiederum um den Betrag der Verstärkung des ersten Verstärkers 2 abgeschwächt werden. Hinsichtlich der Rauschsignal-Unterdrückung und der Symmetrie des Signals S1 aus der Spannungsquelle 1 ergeben sich dann wieder die gleichen vorteilhaften Verhältnisse wie anhand des Ausführungsbeispiels nach Fig. 2 beschrieben ist.

### Patentansprüche

1. Symmetrierschaltungsanordnung zum Umwandeln eines asymmetrischen analogen Eingangssignals (S1) in ein symmetrisches Ausgangssignal (S2, S3), insbesondere zur Zuführung an einen Analog-Digital-Wandler (4) mit symmetrischen Analog-Eingängen, mit

   - -einem ersten Verstärker (2), dessen nicht-invertierender Eingang mit dem analogen Eingangssignal (S1) verbunden ist und dessen Ausgangssignal (S2) auf dessen invertierenden Eingang gegengekoppelt ist;
   - einem zweiten Verstärker (3), dessen nicht-invertierender Eingang auf Masse gelegt ist, dessen invertierender Eingang mit dem Ausgangssignal (S2) des ersten Verstärkers (2) über einen Vorwiderstand (R2) verbunden ist und dessen Ausgangssignal (S3) über einen Gegenkopplungswiderstand (R1) auf seinen invertierenden Eingang gegengekoppelt ist, wobei der Gegenkopplungswiderstand (R1) und der Vorwiderstand (R2) den gleichen Widerstandswert aufweisen,

   **dadurch gekennzeichnet, daß** der Fußpunkt der Signalquelle (1) für das analoge Eingangssignal (S1) mit dem Ausgang des zweiten Verstärkers (3) verbunden ist, derart, daß die Signalquelle (1) Bestandteil einer Gegenkopplungsschleife ist, welche aus dem ersten Verstärker (2), dem Vorwiderstand (R2), dem zweiten Verstärker (3) und der Signalquelle (1) besteht, wobei an den beiden Anschlüssen der Signalquelle (1) ein symmetriertes Klemmensignal generiert wird.

2. Symmetrierschaltungsanordnung nach Anspruch 1, **dadurch gekennzeichnet, daß** das Ausgangssignal (S2) des ersten Verstärkers (2) über einen Spannungsteiler (R3, R4) auf seinen invertierenden Eingang gegengekoppelt ist, wobei der Abgriff des Spannungsteilers (R3, R4) mit dem invertierenden Eingang des ersten Verstärkers (2) verbunden ist.

3. Symmetrierschaltungsanordnung nach Anspruch 1 oder 2, **dadurch gekennzeichnet, daß** das Ausgangssignal (S3) des zweiten Verstärkers (3) über einen Spannungsteiler (R5, R6) auf den Fußpunkt der Signalquelle (1) für das analoge Eingangssignal (S1) gegengekoppelt ist, wobei der Abgriff des Spannungsteilers (R5, R6) mit dem Fußpunkt der Signalquelle (1) verbunden ist.

## Claims

1. Balancing circuit arrangement for converting an unbalanced analogue input signal (S1) into a balanced output signal (S2, S3), particularly for feeding to an analogue-to-digital converter (4) having balanced analogue inputs, said circuit arrangement having

   - a first amplifier (2) whose non-inverting input is connected to the analogue input signal (S1) and whose output signal (S2) is fed back to its inverting input as negative feedback,
   - a second amplifier (3) whose non-inverting input is connected to earth, whose inverting input is connected to the output signal (S2) from the first amplifier (2) via a series resistor (R2), and whose output signal (S3) is fed back via a negative-feedback resistor (R1) to its inverting input as negative feedback, the negative-feedback resistor (R1) and the series resistor (R2) being of the same value,

   **characterised in that** the low end of the signal source (1) for the analogue input signal (S1) is connected to the output of the second amplifier (3) in such a way that the signal source (1) is part of a negative-feedback loop which comprises the first amplifier (2), the series resistor (R2), the second amplifier (3) and the signal source (1), a balanced terminal signal being generated at the two terminals of the signal source (1).

2. Balancing circuit arrangement according to claim 1, **characterised in that** the output signal (S2) from the first amplifier (2) is fed back to its inverting input via a voltage divider (R3, R4) as negative feedback, the pick-off from the voltage divider (R3, R4) being connected to the inverting input of the first amplifier (2).

3. Balancing circuit arrangement according to claim 1 or 2, **characterised in that** the output signal (S3) from the second amplifier (3) is fed back to the low end of the signal source (1) for the analogue input signal (S1) via a voltage divider (R5, R6) as negative feedback, the pick-off from the voltage divider (R5, R6) being connected to the low end of the signal source (1).

## Revendications

1. Dispositif de circuit symétrique pour convertir un signal d'entrée (S1) analogique asymétrique en un signal de sortie (S2, S3) symétrique, en particulier pour l'introduction dans un convertisseur analogique numérique (4) avec des entrées analogiques symétriques, avec

   - un premier amplificateur (2), dont l'entrée non inverseuse est reliée au signal d'entrée (S1) analogique et dont le signal de sortie (S2) est rétrocouplé à son entrée inverseuse ;
   - un deuxième amplificateur (3) dont l'entrée non inverseuse est mise à la masse, dont l'entrée inverseuse est reliée, par l'intermédiaire d'une résistance préliminaire (R2) au signal de sortie (S2) du premier amplificateur (2) et dont le signal de sortie (S3) est rétrocouplé à son entrée inverseuse par l'intermédiaire d'une résistance de rétrocouplage (R1), de sorte que la résistance de rétrocouplage (R1) et la résistance préliminaire (R2) présente la même valeur de résistance,

   **caractérisé en ce que** le point de base de la source de signal (1) pour le signal d'entrée analogique (S1) est relié à la sortie du deuxième amplificateur (3) de sorte que la source de signal (1) est une partie d'une boucle de réaction qui consiste en le premier amplificateur (2), la résistance préliminaire (R2), le second amplificateur (3) et la source de signal (1), afin qu'aux deux bornes de la source de signal (1) soit engendré un signal d'assemblage symétrisé.

2. Dispositif de circuit symétrique selon la revendication 1, **caractérisé en ce que** le signal de sortie (S2) du premier amplificateur (2) est rétrocouplé, par un diviseur de tension (R3, R4) à son entrée inverseuse, de sorte que la prise du diviseur de tension (R3, R4) est reliée à l'entrée inverseuse du premier amplificateur (2).

3.  Dispositif de circuit symétrique selon la revendication 1 ou 2, **caractérisé en ce que** le signal de sortie (S3) du deuxième amplificateur (3) est rétrocouplé au point de base de la source de signal (1) pour le signal d'entrée analogique (S1) par l'intermédiaire d'un diviseur de tension (R5, R6), de sorte que la prise du diviseur de tension (R5, R6) est reliée au point de base de la source de signal (1).

Fig.1

Fig.2

Fig.3